# EUROPEAN PATENT SPECIFICATION

(11) **EP 0 255 274 B1**
(45) Date of publication and mention of the grant of the patent: **05.01.1994**
(21) Application number: 87306382.0
(22) Date of filing: 17.07.1987
(51) Int. Cl.: H04N 5/52, H03G 3/20, H04N 5/16

(54) **Gain control circuits**
Pegelregelschaltungen
Circuits de commande de gain

(30) Priority: 19.07.1986 JP 170330/86
(43) Date of publication of application: 03.02.1988
(73) Proprietor: SONY CORPORATION, Tokyo 141 (JP)
(72) Inventor: Kawai, Ryuichiro Patents Division, Shinagawa-ku Tokyo 141 (JP)
(74) Representative: Thomas, Christopher Hugo

(56) References cited:
- US-A- 3 557 305
- US-A- 3 985 954
- US-A- 4 204 229
- PATENT ABSTRACTS OF JAPAN, vol. 4, no. 109 [E-020], 6th August 1980; & JP-A-55 066 177 (MATSUSHITA ELECTRIC IND. CO. LTD) 19-05-1980
- PATENT ABSTRACTS OF JAPAN, vol. 6, no. 230 (E-142)[1108], 16th November 1982; & JP-A-57 131 175 (NIPPON DENKI K.K.) 13-08-1982

## Description

This invention relates to gain control circuits. Embodiments of the invention are particularly, but not exclusively, suitable for achieving contrast control in the reproduction of video images in television receivers, video tape recorders (VTRs) and the like.

In order to reduce fluctuations in the contrast of reproduced video images resulting from variations in signal strength, receiver sensitivity, phasing, and the like, for example, in television receivers and VTRs, it is known to employ a gain control circuit including first and second clamping circuits, a variable gain amplifier interposed between the clamping circuits, a peak detector sensing peaks in the output of the second clamping circuit, and a comparator which compares the peak detector output with a predetermined voltage to provide therefrom a gain control signal supplied to the variable gain amplifier. It is intended that the first clamping circuit be effective to clamp the pedestal level of the video signal at a reference level before effecting gain control, while the second clamping circuit is intended to achieve a similar clamping action after gain control has been effected.

However, in this gain control circuit, the clamping circuits have fixed follow-up speeds so that, if such follow-up speed is even a little too high, noise superimposed on the input video signal, or noise generated within the variable gain amplifier causes variations in the direct current level of the output video signal, and consequent deterioration of the quality of the reproduced image. On the other hand, if the fixed follow-up speed of the clamping circuits is reduced in an attempt to overcome this problem, the image contrast changes with changes in the level of the received video signal, and the effectiveness of the automatic gain control (AGC) function is reduced or even lost. A gain control circuit including a clamping circuit with a fixed follow-up speed and a variable gain amplifier is disclosed in US-A-3 557 305. In other words, if the clamping circuits have a fixed follow-up speed, such fixed follow-up speed will be either too high or too low in relation to the changing level of the input video signal.

According to the present invention there is provided a gain control circuit comprising:
signal input means;
signal output means;
variable gain means;
clamping circuit means connected in series with said variable gain means between said signal input means and said signal output means;
and
means for generating a gain control signal and supplying it to said variable gain means for controlling the gain thereof;
characterized by:
said clamping circuit means having a variable follow-up speed; and
said gain control signal being supplied to said clamping means for increasing and decreasing said follow-up speed when said gain control signal decreases and increases, respectively, the gain of said variable gain means.

A clamping circuit having a variable response speed is disclosed in PATENT ABSTRACTS OF JAPAN, vol. 4, no 109 [E-020], 6th August 1980; & JP-A-55 066 177 (MATSUSHITA ELECTRIC IND. CO. LTD) 19-05-1980.

The invention will now be described with reference to the accompanying drawings, throughout which like parts are referred to by like references, and in which:
Figure 1 is a block diagram showing a previously proposed gain control circuit;
Figures 2A and 2B are timing charts to which reference will be made in explaining a problem encountered with the gain control circuit of Figure 1;
Figure 3 is a block diagram showing an embodiment of gain control circuit according to the present invention;
Figures 4A and 4B are circuit diagrams illustrating alternative DC shift circuits that may be employed in clamping circuits in the gain control circuit of Figure 3;
Figures 5A and 5B are circuit diagrams showing alternative comparators that can be used in the clamping circuits of Figure 3; and
Figure 6 is a graph illustrating, in terms of clamping power and gain, the characteristics of a follow-up speed control signal.

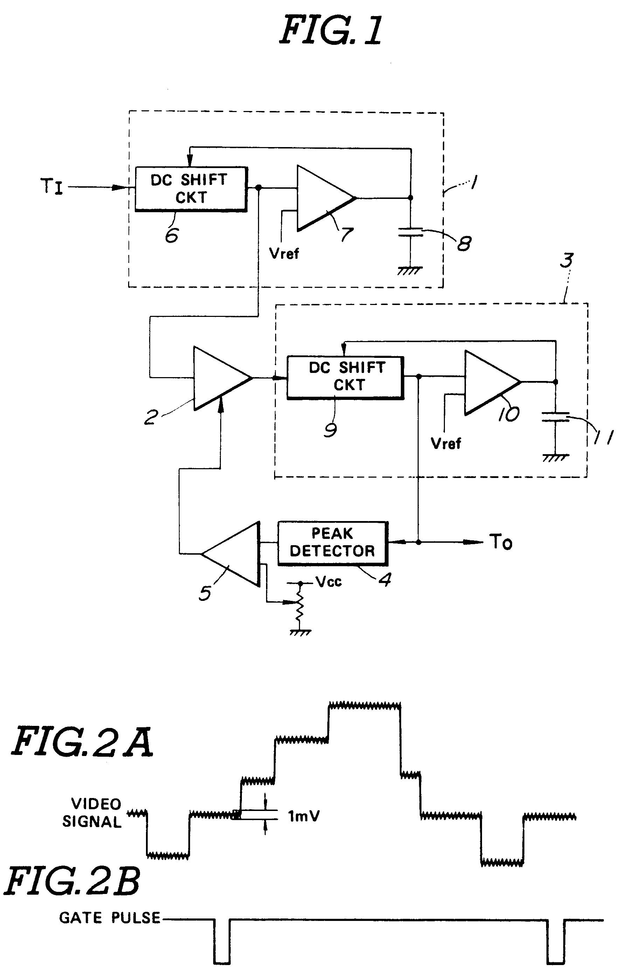

In order that the problems solved by the embodiment may be fully understood, a previously proposed gain control circuit will first be described with reference to Figure 1. This gain control circuit is particularly intended to reduce the fluctuations in the contrast of reproduced video images resulting from variations in signal strength, receiver sensitivity and phasing, for example, in television receivers, VTRs and the like. The gain control circuit includes a first clamping circuit 1, a variable gain amplifier 2 and a second clamping circuit 3 connected in succession between an input terminal TI, which receives an input video signal, and an output terminal TO, at which an output video signal may be derived. A peak detector 4 receives the output of the second clamping circuit 3, and a comparator 5 compares the detected output from the peak detector 4 with a predetermined voltage, and provides a corresponding gain control signal applied to the variable gain amplifier 2 for controlling the gain.

The first clamping circuit 1 includes a DC shift circuit 6 which receives the input video signal from the terminal TI and supplies its DC shifted output to the variable gain amplifier 2 and to one input of a comparator 7 which, at its other input, receives a reference voltage Vref representing the desired DC level of the video signal, for example, at is pedestal interval. The output of the comparator 7 is applied to one electrode of a capacitor 8 acting as a memory or storage element and having its other electrode connected to earth, and the output of the comparator 7 is further applied as a feedback or shift control signal to the DC shift circuit 6.

The clamping circuit 3 similarly includes a DC shift circuit 9 which receives the output of the variable gain amplifier 2, a comparator 10 which compares the output of the DC shift circuit 9 with a reference voltage Vref, and a capacitor 11 connected at one electrode to earth and at its other electrode to the output of the comparator 10 which provides a feedback or shift control signal to the respective DC shift circuit 9. Moreover, the output of the DC shift circuit 9 is connected to the peak detector 4 and to the terminal TO for providing the output video signal.

It will be appreciated that, whenever the peak value detected by the peak detector 4 exceeds the predetermined value, for example, established by a voltage source Vcc and a variable resistor RO, the comparator 5 provides a corresponding gain control signal to the gain control amplifier 2 for correspondingly reducing the gain thereof. In the clamping circuits 1 and 3, the outputs of the DC shift circuits 6 and 9 are compared in the comparators 7 and 10 with the respective reference voltages Vref. When the outputs of the DC shift circuits 6 and 9 exceed the respective reference voltage levels during pedestal intervals of the video signal, the comparators 7 and 10 provide outputs by which the respective capacitors 8 and 11 are charged. On the other hand, when the outputs of the DC shift circuits 6 and 9 fall below the respective reference voltages Vref during the pedestal intervals, the comparators 7 and 10 permit discharging of the capacitors 8 and 11, respectively, with the voltages appearing on the capacitors 8 and 11 being applied to the DC shift circuits 6 and 9, respectively, as feed back or shift control signals therefor.

In each of the clamping circuits 1 and 3, the comparator 7 and 10 is made operative by a gate or clamping pulse (Figure 2B) which is shown to be a low level pulse and is made to occur during each pedestal interval of the video signal received from the DC shift circuit 6 or 9, respectively. In each instance, the pedestal level of the video signal is controlled in response to the feed-back signal to the DC shift circuit 6 or 9 so as to be made equal to the reference level Vref applied to the comparator 7 or 10. More specifically, with the gain control circuit of Figure 1, the pedestal level of the video signal is clamped at the reference level by the first clamping circuit 1 prior to effecting gain control in the variable gain amplifier 2, and a similar clamping effect is achieved by the second clamping circuit 3 after gain control has been effected. The purpose of this is to maintain a substantially constant DC level of the video signal.

However, this gain control circuit suffers from the disadvantage that the clamping circuits 1 and 3 thereof have fixed follow-up speeds. If such fixed follow-up speed of the clamping circuits 1 and 3 is a little too high, noise superimposed on the input video signal and/or noise generated within the variable gain amplifier 2 causes variation of the DC level of the output video signal with the result that the quality of the reproduced image is deteriorated.

More specifically, if it is assumed that the input video signal applied to the terminal TI has a noise level of 1 mV, as is normal and is represented in Figure 2A, and that the fixed follow-up speed of the clamping circuit 1 is too high, then, during the sampling of the output of the comparator 7 in response to the gate or clamping pulse shown in Figure 2B, the level of the output of the comparator 7 will change in accordance with such noise. Since the noise tends to be random, the level of the output of the comparator 7 at the termination of the gate pulse, and which determines the feedback or shift control signal supplied from the capacitor 8 to the DC shift circuit 6 and hence the DC level at which the video signal is clamped, may vary from one sampling or clamping period to the next. Therefore, the DC level of the video signal applied from the clamping circuit 1 to the gain control amplifier 2 will fluctuate in accordance with the noise. Of course, the variable gain amplifier 2 amplifies such fluctuation of DC level of the video signal.

If the fixed follow-up speed of the first clamping circuit 1 is reduced, as, has been proposed for avoiding the above described problem, the image contrast of the reproduced image changes in response to variations in the strength or level of the received electromagnetic or video signal and the effectiveness of the AGC function is reduced or lost. In other words, when the clamping circuits 1 and 3 have fixed follow up speeds, such fixed follow-up speeds will be either undesirably high when the level of the incoming signal is very high, or too low when the level of the incoming video signal is low. Thus, permanently maintaining the follow-up speeds of the clamping circuits 1 and 3 at fixed values will inherently cause fluctuation of the relation of such follow-up speeds to the changing levels of the input signal.

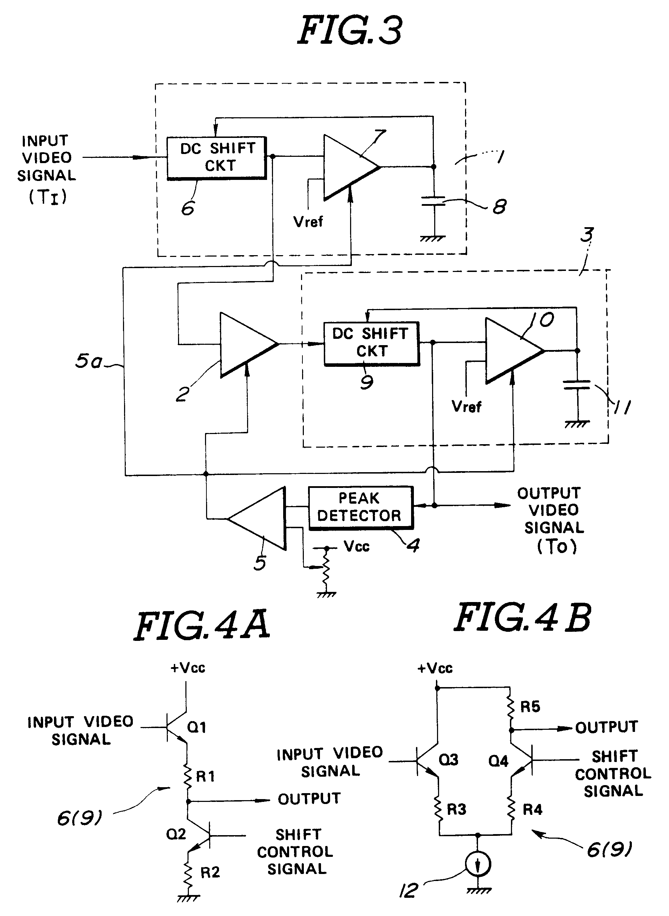

Referring now to Figure 3, the embodiment of gain control circuit according to the present invention differs from that of Figure 1 only in that the output of the comparator 5 which is applied to the variable gain amplifier 2 as a gain control signal, is also applied, as a follow-up characteristic control signal, to the comparator 7 of the clamping circuit 1 and to the comparator 10 of the clamping circuit 3, by the connections 5a and 5b, respectively. With this arrangement, when the input power to the variable gain amplifier 2 rises substantially, such as, when the level of the received or input video signal is high, the output of the comparator 5 is effective in the gain control amplifier 2 to reduce the gain thereof and, simultaneously, the output of the comparator 5 is effective through the connections 5a and 5b to the comparators 7 and 10 to increase the follow-up speeds of the clamping circuits 1 and 3. Conversely, when the level or strength of the received or input video signal is low, the output of the comparator 5 is effective, in the gain control amplifier 2, to increase the gain thereof and, in the clamping circuits 1 and 3, to decrease the follow-up speeds of the clamping circuits 1 and 3.

As shown in Figure 4A, each of the DC shift circuits 6 and 9 included in the clamping circuits 1 and 3 may include an npn-type transistor Q1 which receives, at its base, the video signal input to the respective clamping circuit 1 or 3, and which has its collector connected to a power input source +Vcc. The emitter of the transistor Q1 is connected through a resistor R1 to the collector of an npn-type transistor Q2 which, at its base, receives the shift control signal from the output of the respective comparator 7 or 10. The emitter of the transistor Q2 is connected to earth through a resistor R2, and the output of the DC shift circuit is derived at a junction between the collector of the transistor Q2 and the resistor R1.

When the level of the shift control signal, that is, the charge on the capacitor 8 or 11 fed back to the base of the transistor Q2 in the DC shift circuit 6 or 9, falls to '0', the DC level of the video signal at the output of the DC shift circuit 6 or 9 is not reduced, that is, it remains substantially unchanged, since the change in voltage between the base and emitter of the transistor Q2 is substantially negligible. On the other hand, an increase in the level of the shift control signal fed back to the base of the transistor Q2 in response to an increase in the level of the video signal applied to the comparator 7 or 10 relative to the reference voltage Vref causes an increase in the current flow through the transistor Q2 and also through the resistor R1. Such increased current flow through the resistor R1 causes an increase in the voltage drop across the resistor R1 and, as a result, the DC level of the video signal derived at the junction between the resistor R1 and the collector of transistor Q2 is decreased.

Referring now to Figure 4B, it will be seen that, in a modification to the embodiment, each of the DC shift circuits 6 and 9 included in the clamping circuits 1 and 3, respectively, of the circuit of Figure 3 may comprise an npn-type transistor Q3 which receives the input video signal at its base, and which has its collector connected to a power input source +Vcc while the emitter of the transistor Q3 is connected through a resistor R3 to a voltage stabilizer circuit 12 having an output connected to earth. An npn-type transistor Q4 has its emitter connected through a resistor R4 to a junction between the resistor R3 and the voltage stabilizer circuit 12, and the collector of the transistor Q4 is connected through a resistor R5 to the power input source +Vcc. In the DC shift circuit of Figure 4B, the output is derived from a junction between the collector of the transistor Q4 and the resistor R5, and the shift control signal fed back from the memory capacitor 8 or 11 associated with the comparator 7 or 10, respectively, is applied to the base of the transistor Q4. When the level of the shift control signal applied to the base of the transistor Q4 is increased, the flow of current through the transistor Q4 is correspondingly increased, and the DC level of the video signal derived at the junction between the resistor R5 and the collector of the transistor Q4 is reduced by an amount equivalent to the increase in current flow through the transistor Q4 multiplied by the resistance value of the resistor R5. Conversely, when the level of the shift control signal applied to the base of the transistor Q4 is decreased, the DC level of the video signal output from the DC shift circuit 6 or 9 is increased.

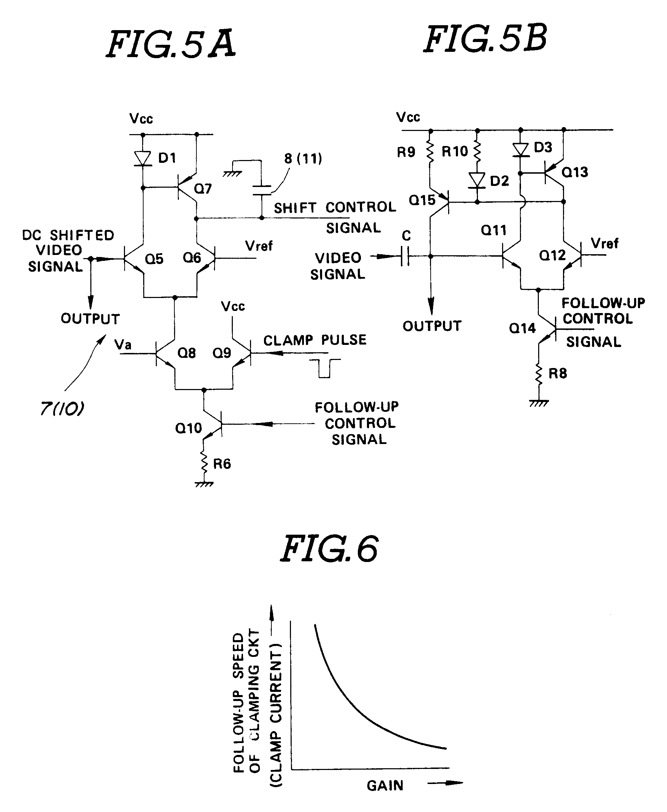

Referring now to Figure 5A, it will be seen that each of the comparators 7 and 10 in the clamping circuits 1 and 3, respectively, may be of a synchronous type comprising an npn-type transistor Q5 which, at its base, receives the output video signal from the DC shift circuit 6 or 9. The collector of the transistor Q5 is connected to the cathode of a diode D1 which has its anode connected to the power input source +Vcc. The emitter of the transistor Q5 is connected to the emitter of an npn-type transistor Q6 which, at its base, receives the reference voltage Vref. The collector of the transistor Q6 is connected to the collector of a pnp-type transistor Q7 which has its emitter connected to the power input source +Vcc, while the base of the transistor Q7 is connected to a junction between the diode D1 and the collector of the transistor Q5. The memory capacitor 8 or 11 of the respective clamping circuit 1 or 3 is connected between the collector of the transistor Q7 and earth, and the output or shift control signal from the comparator 7 or 10 is derived from the electrode of the capacitor 8 or 11 connected to the junction between the collectors of the transistors Q6 and Q7. The connected-together emitters of the transistors Q5 and Q6 are connected to the collector of an npn-type transistor Q8 which has its base connected to a source of a predetermined potential Va. The emitters of the transistor Q8 and of an npn-type transistor Q9 are connected in common to the collector of an npn-type transistor Q10 which has its emitter connected through a resistor R6 to earth. The base of the transistor Q10 receives the follow-up characteristic or speed control signal, that is, the gain control signal from the output of the comparator 5, and the transistor Q9 has its collector connected to the power input source +Vcc and its base connected to receive the gate or clamp pulse signal (Figure 2B). As shown, such gate or clamp pulse signal is normally maintained at a relatively high level, and is changed-over to its low level during the period when the difference between the level of the video signal from the DC shift circuit 6 or 9 and the reference voltage Vref is to be sampled, for example, only during the pedestal interval of the video signal.

In the circuit of Figure 5A, the transistor Q8 is turned ON or rendered conductive only during each sampling period, that is, when the gate or clamp pulse is at a low level during the pedestal interval of the video signal. If the pedestal level of the video signal is higher than the reference voltage Vref, the transistor Q5 will transmit a larger current than the transistor Q6 at the time when the transistor Q8 is turned ON. The current which flows through transistor Q7 is larger than the current which flows through the transistor Q5 and hence greater than the current flowing through the transistor Q6 with the result that the current flowing through the transistor Q7 flows, in part, to the memory capacitor 8 or 11 for charging it. When the gate or clamp pulse applied to the base of the transistor Q9 returns to its normal high level, the transistor Q8 is rendered non-conductive or turned OFF, with the result that the charge on the memory capacitor 8 or 11 is held thereby until the beginning of the next sampling period. Such charge on the memory capacitor 8 or 11 is fed back as the shift control signal to the associated DC shift circuit 6 or 9 with the result that the DC level or the video signal is reduced when the sampled pedestal level is higher than the reference voltage Vref.

On the other hand, when the sampled pedestal level on the video signal is lower than the reference level Vref, the current flow through the transistor Q5 during the sampling period is lower than the current flow through the transistor Q6, and the current flow through the transistor Q7 is also less than the current flow through the transistor Q6. Therefore, the current flowing through the transistor Q6 includes current flowing from the memory capacitor 8 or 11 which is thereby discharged with the result that the level of the shift control signal applied to the respective DC shift circuit 6 or 9 is lowered and, in response thereto, the shift control circuit increases the DC level of the video signal.

However, it will be apparent from Figure 5A that the total current flow through the transistors Q5 and Q6 is determined by the level of the follow-up control signal applied to the base of the transistor Q10 from the output of the comparator 5. Accordingly, the total current flow through the transistors Q5 and Q6 increases and decreases in accordance with increasing and decreasing, respectively, of the level of the follow up control signal from the output of the comparator 5. The clamping control of the comparator 7 or 10, that is, its follow-up speed, is therefore controlled by the follow-up control signal from the comparator 5.

Referring now to Figure 5B, it will be seen that the present invention may also be embodied in a gain control circuit which employs clamping circuits of the asynchronous type. One such clamping circuit of the asynchronous type is shown in Figure 5B to include an npn-type transistor Q11 which receives the video signal, at its base, by way of a capacitor C. The collector of the transistor Q11 is connected to the cathode of a diode D3 which has its anode connected to a power input source +Vcc. The emitter of the transistor Q11 is connected with the emitter of an npn-type transistor Q12 which receives the reference level Vref at its base, and which has its collector connected to the collector of a pnp-type transistor Q13. The emitter of the transistor Q13 is connected to the power input source +Vcc, and the base of the transistor Q13 is connected to a junction between the diode D3 and the collector of the transistor Q11. The collector of an npn-type transistor Q14 is connected to the connected-together emitters of the transistors Q11 and Q12. The base of the transistor Q14 receives the follow-up control signal, for example, from the comparator 5 in Figure 3, and the emitter of the transistor Q14 is connected to earth through a resistor R8. The base of a pnp-type transistor Q15 is connected to a junction between the collectors of the transistors Q12 and Q13, and also to the cathode of a diode D2 which has its anode connected to the power input source +Vcc through a resistor R10.

The emitter of the transistor Q15 is connected to the power input source +Vcc through a resistor R9, and the collector of the transistor Q15 is connected to a junction between the capacitor C and the base of the transistor Q11. Finally, in the clamping circuit of Figure 5B, the shift control signal for an associated DC shift circuit (not shown) is derived from the junction between the capacitor C and the base of the transistor Q11.

In the operation of the clamping circuit of Figure 5B, the reference level Vref is made to correspond with the desired lowest level of the video signal, that is, with its synchronizing signal level. The input video signal applied through the capacitor C to the base of the transistor Q11 is compared with the reference voltage Vref applied to the base of the transistor Q12. In the event that the input video signal, and more particularly the synchronizing signal portion thereof, has a voltage lower than that of the reference voltage Vref, the transistor Q12 is turned ON with the result that the capacitor C is charged, and the DC level of the video signal is shifted. Therefore this case uses the capacitor C as a memory capacitor and the DC level shift means. In this case, the total current flow through the transistors Q11 and Q12 is determined by the follow-up control signal applied to the transistor Q14 from the comparator 5 in Figure 3. Thus, when the level of the follow-up control signal increases, the total current flow through the transistors Q11 and Q12 is increased for increasing the follow-up or clamping speed of the clamping circuit.

When the described embodiments of the invention are arranged so as to provide the relationship between the gain and the follow-up speed of the clamping circuit (or clamp current) shown in Figure 6, particularly good results are achieved. However, substantial advantages are attained in the gain control circuits even when the relation of the gain to the follow-up speed of the clamping circuits is not varied in accordance with the relationship indicated in Figure 6.

## Claims

1. A gain control circuit comprising:
signal input means (TI);
signal output means (TO);
variable gain means (2);
clamping circuit means (1, 3) connected in series with said variable gain means (2) between said signal input means (TI) and said signal output means (TO); and
means (4, 5, 5a, 5b) for generating a gain control signal and supplying it to said variable gain means (2) for controlling the gain thereof;
characterized by:
said clamping circuit means (1, 3) having a variable follow-up speed; and
said gain control signal being supplied to said clamping means (1, 3) for increasing and decreasing said follow-up speed when said gain control signal decreases and increases, respectively, the gain of said variable gain means (2).

2. A gain control circuit according to claim 1 wherein said means (4, 5, 5a, 5b) for generating a gain control signal induces a follow-up speed of said clamping circuit means (1, 3) inversely proportional to the magnitude of said gain.

3. A gain control circuit according to claim 2 wherein said means (4, 5, 5a, 5b) for generating said gain control signal includes peak detecting means (4) connected to said signal output means (TO) for providing a detected output, and comparator means (5) for providing said gain control signal in correspondence to a comparison of said detected output with a predetermined voltage.

4. A gain control circuit according to claim 1 wherein said clamping circuit means (1, 3) includes at least a first clamping circuit (1) arranged prior to said variable gain means (2).

5. A gain control circuit according to claim 4 wherein said clamping circuit means (1, 3) further includes a second clamping circuit (3) arranged after said variable gain means (2), the follow-up speeds of said first and second clamping circuits (1, 3) both being controlled by said gain control signal.

6. A gain control circuit according to claim 1 wherein said clamping circuit means (1, 3) includes a clamping circuit (3) arranged after said variable gain means (2).

7. A gain control circuit according to claim 1 wherein said signal input means (TI) receives a video signal; and wherein said clamping circuit means (1, 3) includes DC shift circuit means (6, 9) for varying the DC level of the video signal, comparator means (7, 10) for comparing a level of the video signal from said DC shift circuit means (6, 9) with a reference voltage level and providing a comparison output, capacitive means (8, 11) for storing said comparison output and providing therefrom a shift control signal fed back to said DC shift circuit means (6, 9) for determining said DC level of the video signal, and means (7, 10) responsive to said gain control signal for determining said follow-up speed as the speed with which said comparator means (7, 10) responds to changes in said level of the video signal from said DC shift circuit means (6, 9).

8. A gain control circuit according to claim 9 wherein said DC shift circuit means (6, 9) includes first and second transistors (Q1, Q2), said first transistor (Q1) having a base arranged to receive an input video signal, a collector connected with a source of power and an emitter connected to a collector of said second transistor (Q2) through a first resistor (R1), said second transistor (Q2) having a base arranged to receive said shift control signal and an emitter which is connected to earth through a second resistor (R2), and an output connected to a junction between said first resistor (R1) and the collector of said second transistor (Q2).

9. A gain control circuit according to claim 7 wherein said DC shift circuit means (6, 9) includes first and second transistors (Q3, Q4), voltage stabilizer means (12), said first transistor (Q3) having a base which receives an input video signal, a collector connected with a source of power and an emitter connected to earth through a first resistor (R3) and said voltage stabilizer means (12), said second transistor (Q4) having a base which receives said shift control signal, an emitter connected with said voltage stabilizer means (12) through a second resistor (R4), and a collector connected to said source of power through a third resistor (R5), and an output connected to a junction between said third resistor (R5) and the collector of said second transistor (Q4).

10. A gain control circuit according to claim 7 wherein said comparator means (7, 10) includes a first transistor (Q5) having a base receiving said video signal from said DC shift circuit means (6,9), a collector and an emitter; a source of power; a diode (D1) through which the collector of said first transistor (Q5) is connected to said source of power; a second transistor (Q6) having a base receiving said reference voltage level, an emitter connected with the emitter of said first transistor (Q5) and a collector; a third transistor (Q7) having a base connected to a junction between said diode (D1) and the collector of said first transistor (Q5), a collector connected to the collector of said second transistor (Q6) and an emitter connected to said source of power; a fourth transistor (Q8) having a base receiving a predetermined voltage, a collector connected to the connected-together emitters of said first and second transistors (Q5, Q6) and an emitter; a fifth transistor (Q9) having an emitter connected to the emitter of said fourth transistor (Q8), a collector connected to said source of power and a base receiving a clamp pulse; and a sixth transistor (Q10) having a collector connected to the connected-together emitters of said fourth and fifth transistors (Q8, Q9), an emitter connected through a resistor (R6) to earth and a base receiving said gain control signal so that said sixth transistor (Q10) forms said means for determining said follow-up speed; and wherein said capacitive means (8, 11) is connected to a junction between the collectors of said second and third transistors (Q6, Q7) and at which said shift control signal is derived.

11. A gain control circuit according to claim 10 wherein said reference voltage level is a desired pedestal level for said video signal, and said clamp pulse is timed to render said fourth transistor (Q8) conductive during each pedestal interval of the video signal.

12. A gain control circuit according to claim 7 wherein said comparator means (7, 10) includes a first transistor (Q11) having abase connected to receive the video signal through said capacitive means (8, 11), a collector and an emitter; a source of power; a first diode (D3) through which the collector of said first transistor (Q11) is connected to said source of power; a second transistor (Q12) having a base receiving said reference voltage level, an emitter connected to the emitter of said first transistor (Q11) and a collector; a third transistor (Q13) having a collector connected to the collector of a said second transistor (Q12), an emitter connected to said source of power and a base connected to a junction between said first diode (D3)and the collector of said first transistor (Q11), a fourth transistor (Q14) having a collector connected to the connected-together emitters of said first and second transistors (Q11, Q12), an emitter connected through a first resistor (R8) to earth, and a base receiving said gain control signal so that said fourth transistor (Q14) forms said means for determining said follow-up speed; a fifth transistor (Q15) having an emitter connected to said source of power through a second resistor (R9), a collector connected to a junction located between said capacitive means (8, 11) and the base of said first transistor (Q11)and at which an output signal is derived, and a base connected to a junction between the collectors of said second and third transistors(Q12, Q13); and a second diode (D2) connected with a third resistor(R10) between the base of said fifth transistor (Q15) and said source of power.

13. A gain control circuit according to claim 12 wherein said reference voltage level is the desired synchronizing level of said video signal.

## Patentansprüche

1. Verstärkungssteuerschaltung, bestehend aus:
einem Signaleingang (TI),
einem Signalausgang (TO),
einem variablen Verstärker (2),
einer zwischen dem Signaleingang (TI) und dem Signalausgang (TO) in Reihe zum variablen Verstärker (2) geschalteten Klemmschaltungseinrichtung (1, 3), und
einer Einrichtung (4, 5, 5a, 5b) zur Erzeugung eines Verstärkungssteuersignals und Zuführung des Verstärkungssteuersignals zum variablen Verstärker (2) zur Steuerung der Verstärkung des variablen Verstärkers,
**dadurch gekennzeichnet,** daß
die Klemmschaltungseinrichtung (1, 3) eine variable Folgegeschwindigkeit aufweist, und
das Verstärkungssteuersignal der Klemmschaltungseinrichtung (1, 3) zur Erhöhung und/oder Erniedrigung der Folgegeschwindigkeit zuführbar ist, wenn das Verstärkungssteuersignal die Verstärkung des variablen Verstärkers (2) erniedrigt bzw. erhöht.

2. Schaltung nach Anspruch 1,
**dadurch gekennzeichnet,**
daß die Einrichtung (4, 5, 5a, 5b) zur Erzeugung des Verstärkungssteuersignals eine zur Größe der Verstärkung umgekehrt proportionale Folgegeschwindigkeit der Klemmschaltungseinrichtung (1, 3) induziert.

3. Schaltung nach Anspruch 2,
**dadurch gekennzeichnet,**
daß die Einrichtung (4, 5, 5a, 5b) zur Erzeugung des Verstärkungssteuersignals eine Spitzenwertdetektoreinrichtung (4), die mit dem Signalausgang (TO) zur Erzeugung eines detektierten Ausgangssignals verbunden ist, und einen Komparator (5) zur Erzeugung des Verstärkungssteuersignals entsprechend einem Vergleich des detektierten Ausgangssignals mit einer vorbestimmten Spannung aufweist.

4. Schaltung nach Anspruch 1,
**dadurch gekennzeichnet,**
daß die Klemmschaltungseinrichtung (1,3) wengistens eine dem variablen Verstärker (2) vorgeschaltete Klemmschaltung (1) aufweist.

5. Schaltung nach Anspruch 4,
**dadurch gekennzeichnet,**
daß die Klemmschaltungseinrichtung (1, 3) eine dem Verstärker (2) nachgeschaltete Klemmschaltung (3) aufweist.

6. Schaltung nach Anspruch 1,
**dadurch gekennzeichnet,**
daß die Folgegeschwindigkeit sowohl der vor- (1) als auch der nachgeschalteten Klemmschaltung (3) durch das Verstärkungssteuersignal gesteuert ist.

7. Schaltung nach Anspruch 1,
**dadurch gekennzeichnet,**
daß der Signaleingang (TI) ein Videosignal empfangt, und daß die Klemmschaltungseinrichtung (1, 3) eine Gleichspannungsverschiebeschaltungseinrichtung (6, 9) zur Variation des Gleichspannungspegels des Videosignals, eine Komparatoreinrichtung (7, 10) zum Vergleich eines Pegels des Videosignals aus der Gleichspannungsverschiebeschaltungseinrichtung (6, 9) mit einem Bezugsspannungspegel und Bereitstellen eines Vergleichsausgangssignals, eine Kapazitätseinrichtung (8, 11) zum Speichern des Vergleichsausgangssignals und Erzeugen einer Verschiebesteuersignalrückkopplung zur Gleichspannungsverschiebeschaltungseinrichtung (6, 9) zur Bestimmung des Gleichspannungspegels des Videosignals und eine auf das Verstärkungssteuersignal ansprechende Einrichtung (7, 10) zur Bestimmung der Folgegeschwindigkeit als die Geschwindigkeit, mit welcher die Komparatoreinrichtung (7, 10) auf Änderungen des Pegels des Videosignals aus der Gleichspannungsverschiebeschaltungseinrichtung (6, 9) anspricht, aufweist.

8. Schaltung nach Anspruch 7,
**dadurch gekennzeichnet,**
daß die Gleichspannungsverschiebeschaltungseinrichtung (6, 9) einen ersten und zweiten Transistor (Q1, Q2) und einen Ausgang aufweist, daß der erste Transistor (Q1) eine Basis zum Empfang eines Eingangsvideosignals, einen mit einer Energiequelle verbundenen Kollektor und einen durch einen ersten Widerstand (R1) mit einem Kollektor des zweiten Transistors (Q2) verbundenen Emitter aufweist, daß der zweite Transistor (Q2) eine Basis zum Empfang des Verschiebesteuersignals und einen durch einen zweiten Widerstand (R2) mit Erde verbundenen Emitter aufweist, und daß der Ausgang mit einer Verbindung zwischen dem ersten Widerstand (R1) und dem Kollektor des zweiten Transistors (Q2) verbunden ist.

9. Schaltung nach Anspruch 7,
**dadurch gekennzeichnet,**
daß die Gleichspannungsverschiebeschaltungseinrichtung (6, 9) einen ersten und zweiten Transistor (Q3, Q4), eine Spannungsstabilisierungseinrichtung (12) und einen Asugang aufweist, daß der erste Transistor (Q3) eine Basis zum Empfang eines Eingangsvideosignals, einen mit einer Energiequelle verbundenen Kollektor und einen durch einen ersten Widerstand (R3) und die Spannungsstabilisierungseinrichtung (12) mit Erde verbundenen Emitter aufweist, daß der zweite Transistor (Q4) eine Basis zum Empfang des Verschiebesteuerungssignals, einen durch einen zweiten Widerstand (R4) mit der Spannungsstabilisieurngseinrichtung (12) verbundenen Emitter und einen durch einen dritten Widerstand (R5) mit der Energiequelle verbundenen Kollektor aufweist, und daß der Ausgang mit einer Verbindung zwischen dem dritten Widerstand (R5) und dem Kollektor des zweiten Transistors (Q4) verbunden ist.

10. Schaltung nach Anspruch 7,
**dadurch gekennzeichnet,**
daß die Komparatoreinrichtung (7, 10) einen ersten Transistor (Q5) mit einer das Videosignal aus der Gleichspannungsverschiebeschaltungseinrichtung (6, 9) empfangenden Basis, einem Kollektor und einem Emitter, eine Energiequelle, eine den Kollektor des ersten Transistors (Q5) mit der Energiequelle verbindende Diode (D1), einen zweiten Transistor (Q6) mit einer den Bezugsspannungspegel empfangenden Basis, einem mit dem Emitter des ersten Transistor (Q5) verbundenen Emitter und einem Kollektor, einen dritten Transistor (Q7) mit einer mit einer Verbindung zwischen der Diode (D1) und dem Kollektor des ersten Transistors (Q5) verbundenen Basis, einem mit dem Kollektor des zweiten Transistors (Q6) verbundenen Kollektor und einem mit der Energiequelle verbundenen Emitter, einen vierten Transistor (Q8) mit einer eine vorbestimmte Spannung empfangenden Basis, einem mit den miteinander verbundenen Emittern des ersten und zweiten Transistors (Q5, Q6) verbundenen Kollektor und einem Emitter, einen fünften Transistor (Q9) mit einem mit dem Emitter des vierten Transistors (Q8) verbundenen Emitter, einem mit der Energiequelle verbundenen Kollektor und einer einen Klemmimpuls empfangenden Basis, und einen sechsten Iransistor (Q10) mit einem mit den miteinander verbundenen Emittern des vierten und fünften Transistors (Q8, Q9) verbundenen Kollektor, einem durch einen Widerstand (R6) mit Erde verbundenen Emitter und einer das Verstärkungssteuersignal empfangenden Basis, so daß der sechste Transistor (Q10) die Einrichtung zur Bestimmung der Folgegeschwindigkeit bildet, aufweist, und daß die Kapazitätseinrichtung (8, 11) mit einer Verbindung zwischen den Kollektoren des ersten und dritten Transistors (Q6, Q7), von welcher das Verschiebesteuersignal abgeleitet ist, verbunden ist.

11. Schaltung nach Anspruch 10,
**dadurch gekennzeichnet,**
daß der Bezugsspannungspegel ein wahlbarer Schwarzwertpegel des Videosignals ist, und daß der Klemmimpuls derart zeitgesteuert ist, daß der vierte Transistor (Q8) während des Schwarzwertpegelintervalls des Videosignals leitend gemacht ist.

12. Schaltung nach Anspruch 7,
**dadurch gekennzeichnet,**
daß die Komparatoreinrichtung (7, 10) einen ersten Transistor (Q11) mit einer zum Empfang des Videosignals durch die Kapazitätseinrichtung (8, 11) geschalteten Basis, einem Kollektor und einem Emitter, eine Energiequelle, eine den Kollektor des ersten Transistors (Q11) mit der Energiequelle verbindende erste Diode (D3), einen zweiten Transistor (Q12) mit einer den Bezugsspannungspegel empfangenden Basis, einem mit dem Emitter des ersten Transistors (Q11) verbundenen Emitter und einem Kollektor, einen dritten Iransistor (Q13) mit einem mit dem Kollektor des zweiten Transistors (Q12) verbundenen Kollektor, einem mit der Energiequelle verbundenen Emitter und einer mit einer Verbindung zwischen der ersten Diode (D3) und dem Kollektor des ersten Transistors (Q11) verbundenen Basis, einen vierten Transistor (Q14) mit einem mit den miteinander verbundenen Emittern des ersten und zweiten Transistors (Q11, Q12) verbundenen Kollektor, einem durch einen ersten Widerstand (R8) mit Erde verbundenen Emitter und einer das Verstärkungssteuersignal empfangenden Basis, so daß der vierte Transistor (Q14) die Einrichtung zur Bestimmung der Folgegeschwindigkeit bildet, einen fünften Transistor (Q15) mit einem durch einen zweiten Widerstand (R9) mit der Energiequelle verbundenen Emitter, einem mit einer Verbindung zwischen der kapazitiven Einrichtung (8, 11) und der Basis des ersten Transistors (Q11), an welcher ein Ausgangssignal ableitbar ist, verbundenen Kollektor und einer mit einer Verbindung zwischen den Kollektoren des zweiten und dritten Transistors (Q12, Q13) verbundenen Basis, und eine mit einem dritten Widerstand (R10) zwischen der Basis des fünften Transistors (Q15) und der Energiequelle geschaltete zweite Diode (D2) aufweist.

13. Schaltung nach Anspruch 12,
**dadurch gekennzeichnet,**
daß der Bezugspannungspegel der gewünschte Synchronisierungspegel des Videosignals ist.

## Revendications

1. Circuit de commande du gain comprenant :
- un moyen d'entrée du signal (TI);
- un moyen de sortie du signal (TO);
- un moyen de gain variable (2);
- des moyens de circuit de blocage (1, 3) montés en série avec ledit moyen de gain variable (2) entre ledit moyen d'entrée de signal (TI) et ledit moyen de sortie de signal (TO); et
- des moyens (4, 5, 5a, 5b) pour générer un signal de commande du gain et pour le fournir audit moyen de gain variable (2) pour commander son gain;
circuit caractérisé par le fait que :
- lesdits moyens de circuit de blocage (1, 3) possèdent une vitesse de suivi variable; et
- ledit signal de commande du gain est fourni auxdits moyens de blocage (1, 3) pour augmenter et diminuer ladite vitesse de suivi lorsque ledit signal de commande du gain diminue et augmente respectivement le gain dudit moyen de gain variable (2).

2. Circuit de commande du gain selon la revendication 1, dans lequel lesdits moyens (4, 5, 5a, 5b) pour la génération d'un signal de commande du gain induit une vitesse de suivi desdits moyens de blocage (1, 3) de façon inversement proportionnelle à l'amplitude dudit gain.

3. Circuit de commande du gain selon la revendication 2, dans lequel lesdits moyens (4, 5, 5a, 5b) pour la génération dudit signal de commande du gain comprennent un moyen de détection de pic (4) raccordé audit moyen de sortie du signal (TO) pour fournir une sortie détectée et un moyen de comparateur (5) pour fournir ledit signal de commande du gain selon une comparaison de ladite sortie détectée avec une tension prédéterminée.

4. Circuit de commande du gain selon la revendication 1, dans lequel lesdits moyens de blocage (1, 3) comprennent au moins un premier circuit de blocage (1) placé avant ledit moyen de gain variable (2).

5. Circuit de commande du gain selon la revendication 4, dans lequel lesdits moyens de blocage (1, 3) comprennent, de plus, un second circuit de blocage (3) placé après ledit moyen de gain variable (2), les vitesses de suivi desdits premier et second moyens de blocage (1, 3) étant, toutes les deux, commandées par ledit signal de commande du gain.

6. Circuit de commande du gain selon la revendication 1, dans lequel lesdits moyens de blocage (1, 3) comprennent un circuit de blocage 3 placé après ledit moyen de gain variable (2).

7. Circuit de commande du gain selon la revendication 1, dans lequel ledit moyen d'entrée du signal (TI) reçoit un signal vidéo et dans lequel lesdits moyens de blocage (1, 3) comprennent des moyens de circuit de décalage D.C. (6, 9) pour faire varier le niveau D.C. du signal vidéo, des moyens de comparateur (7, 10) pour comparer un niveau du signal vidéo à partir desdits moyens de circuit de décalage D.C. (6, 9) avec un niveau de tension de référence et fournissant une sortie de comparaison, des moyens capacitifs (8, 11) pour stocker ladite sortie de comparaison et fournir une rétroaction d'un signal de commande de décalage auxdits moyens de circuit de décalage D.C. (6, 9) pour la détermination dudit niveau D.C. du signal vidéo et des moyens (7, 10) sensibles audit signal de commande du gain pour déterminer ladite vitesse de suivi comme la vitesse à laquelle lesdits moyens de comparateur (7, 10) réagissent aux variations dudit niveau du signal vidéo à partir desdits moyens de circuit de décalage D.C. (6, 9).

8. Circuit de commande du gain selon la revendication 9, dans lequel lesdits moyens de circuit de décalage D.C. (6, 9) comprennent des premier et second transistors (Q1, Q2), ledit premier transistor (Q1) possédant une base prévue pour recevoir un signal vidéo d'entrée, un collecteur raccordé à une source de puissance et un émetteur raccordé à un collecteur dudit second transistor (Q2) via une première résistance (R1), ledit second transistor (Q2) possédant une base prévue pour recevoir ledit signal de commande de décalage et un émetteur raccordé à la masse via une seconde résistance (R2) et une sortie raccordée à une jonction entre ladite première résistance (R1) et le collecteur dudit second transistor (Q2).

9. Circuit de commande du gain selon la revendication 7, dans lequel lesdits moyens de circuit de décalage D.C. (6, 9) comprennent des premier et second transistors (Q3, Q4), un moyen de stabilisateur de tension (12), ledit premier transistor (Q3) possédant une base recevant un signal vidéo d'entrée, un collecteur raccordé à une source de puissance et un émetteur raccordé à la masse via une première résistance (R3) et ledit moyen de stabilisateur de tension (12), ledit second transistor (Q4) possédant une base recevant ledit signal de commande du décalage, un émetteur raccordé audit moyen de stabilisateur de tension (12) via une seconde résistance (R4) et un collecteur raccordé à ladite source de puissance via une troisième résistance (R5) et une sortie raccordée à une jonction entre ladite troisième résistance (R5) et le collecteur dudit second transistor (Q4).

10. Circuit de commande du gain selon la revendication 7, dans lequel lesdits moyens de comparateur (7, 10) comprennent :
- un premier transistor (Q5) possédant une base recevant ledit signal vidéo desdits moyens de circuit de décalage D.C. (6, 9), un collecteur et un émetteur;
- une source de puissance;
- une diode (D1) à travers laquelle le collecteur dudit premier transistor (Q5) est raccordé à ladite source de puissance;
- un second transistor (Q6) muni d'une base recevant ledit niveau de tension de référence, d'un émetteur raccordé à l'émetteur dudit premier transistor (Q5) et d'un collecteur;
- un troisième transistor (Q7) muni d'une base raccordée à une jonction entre ladite diode (D1) et le collecteur dudit premier transistor (Q5), d'un collecteur raccordé au collecteur dudit second transistor (Q6) et d'un émetteur raccordé à ladite source de puissance;
- un quatrième transistor (Q8) muni d'une base recevant une tension prédéterminée, d'un collecteur raccordé aux émetteurs communs desdits premier et second transistors (Q5, Q6) et d'un émetteur;
- un cinquième transistor (Q9) possédant un émetteur raccordé à l'émetteur dudit quatrième transistor (Q8), un collecteur raccordé à ladite source de puissance et une base recevant une impulsion de verrouillage; et
- un sixième transistor (Q10) possédant un collecteur raccordé aux émetteurs communs desdits quatrième et cinquième transistors (Q8, Q9), un émetteur raccordé via une résistance (R6) à la masse et une base recevant ledit signal de commande du gain de façon à ce que ledit sixième transistor (Q10) forme ledit moyen de détermination de ladite vitesse de suivi; et
dans lequel lesdits moyens capacitifs (8, 11) sont raccordés à une jonction entre les collecteurs desdits second et troisième transistors (Q6, Q7) et de laquelle ledit signal de commande de décalage est dérivé.

11. Circuit de commande du gain selon la revendication 10, dans lequel ledit niveau de tension de référence est un niveau de base désirée pour ledit signal vidéo et ladite impulsion de verrouillage est cadencée pour rendre ledit quatrième transistor (Q8) passant pendant chaque intervalle de base du signal vidéo.

12. Circuit de commande du gain selon la revendication 7, dans lequel lesdits moyens de comparateurs (7, 10) comprennent :
- un premier transistor (Q11) muni d'une base raccordé pour recevoir le signal vidéo via lesdits moyens capacitifs (8, 11), d'un collecteur et d'un émetteur;
- une source de puissance;
- une première diode (D3) à travers laquelle le collecteur dudit premier transistor (Q11) est raccordé à ladite source de puissance;
- un second transistor (Q12) possédant une base recevant ledit niveau de tension de référence, un émetteur raccordé à l'émetteur dudit premier transistor (Q11) et un collecteur;
- un troisième transistor (Q13) possédant un collecteur raccordé au collecteur dudit second transistor (Q12), un émetteur raccordé à ladite source de puissance et une base raccordée à une jonction entre ladite première diode (D3) et le collecteur dudit premier transistor (Q11);
- un quatrième transistor (Q14) possédant un collecteur raccordé aux émetteurs communs desdits premier et second transistors (Q11, Q12), un émetteur raccordé via une première résistance (R8) à la masse et une base recevant ledit signal de commande du gain de façon à ce que ledit quatrième transistor (Q14) forme ledit moyen de détermination de ladite vitesse de suivi;
- un cinquième transistor (Q15) possédant un émetteur raccordé à ladite source de puissance via une seconde résistance (R9), un collecteur raccordé à une jonction située entre lesdits moyens capacitifs (8, 11) et la base dudit premier transistor (Q11) et de laquelle un signal de sortie est dérivé et une base raccordée à une jonction entre les collecteurs desdits second et troisième transistors (Q12, Q13); et
- une seconde diode (D2) raccordée à une troisième résistance (R10) entre la base dudit cinquième transistor (Q15) et ladite source de puissance.

13. Circuit de commande du gain selon la revendication 12, dans lequel ledit niveau de tension de référence est le niveau synchronisé désiré dudit signal vidéo.
